# FASCICULE DE BREVET EUROPEEN

(11) **EP 3 609 938 B1**
(45) Date de publication et mention de la délivrance du brevet: **08.04.2026**
(21) Numéro de dépôt: 18719971.6
(22) Date de dépôt: 12.04.2018
(51) Int. Cl.: C08F 214/22, C09D 4/06, C08F 214/18, C08F 259/08, C08J 3/24, H10N 30/081, H10N 30/098, H10N 30/857

(54) **COMPOSITIONS RETICULABLES A BASE DE COPOLYMERES FLUORES ELECTROACTIFS**
VERNETZBARE ZUSAMMENSETZUNGEN AUF BASIS VON ELEKTROAKTIVEN FLUORIERTEN COPOLYMEREN
CROSSLINKABLE COMPOSITIONS BASED ON ELECTROACTIVE FLUORINATED COPOLYMERS

(30) Priorité: 14.04.2017 FR 1753291
(43) Date de publication de la demande: 19.02.2020
(73) Titulaire: Arkema France, 92800 Puteaux (FR)
(72) Inventeur: DOMINGUES DOS SANTOS, Fabrice, 75003 Paris (FR); HIDALGO, Manuel, 69530 Brignais (FR); SOULESTIN, Thibaut, 69493 PIERRE-BENITE CEDEX (FR)
(74) Mandataire: Arkema Patent
(86) Numéro de dépôt international: PCT/FR2018/050921
(87) Numéro de publication internationale: WO 2018/189489

(56) Documents cités:
- WO-A1-2013/087500
- WO-A1-2015/128337
- YU JIN SHIN ET AL: "Chemically Cross-Linked Thin Poly(vinylidene fluoride-co-trifluoroethylene)Films for Nonvolatile Ferroelectric Polymer Memory", ACS APPLIED MATERIALS & INTERFACES, vol. 3, no. 2, 23 February 2011 (2011-02-23), US, pages 582 - 589, XP055429974, ISSN: 1944-8244, DOI: 10.1021/am1011657
- SHAOBO TAN ET AL: "Significantly improving dielectric and energy storage properties via uniaxially stretching crosslinked P(VDF-co-TrFE) films", JOURNAL OF MATERIALS CHEMISTRY A: MATERIALS FOR ENERGY AND SUSTAINABILITY, vol. 1, no. 35, 25 June 2013 (2013-06-25), GB, pages 10353, XP055429969, ISSN: 2050-7488, DOI: 10.1039/c3ta11484h

## Description

### DOMAINE TECHNIQUE

La présente invention concerne des compositions réticulables à base de copolymères fluorés électroactifs, des films réticulés obtenus à partir de telles compositions ainsi qu'un procédé de préparation de ces films. L'invention se rapporte également à l'utilisation desdits films en tant que couche électroactive au sein de dispositifs (opto)électroniques divers : piézoélectriques, ferroélectriques, pyroélectriques, actionneurs, haptiques, de capteurs, de transistors à effet de champs, de mémoires ferroélectriques, ou de microsystèmes électromécaniques.

### ARRIÈRE-PLAN TECHNIQUE

Les « polymères électroactifs » ou EAPS (Electroactive polymers) sont des polymères capables de convertir l'énergie mécanique ou thermique en électricité ou vice-versa. Parmi ces matériaux figurent les copolymères fluorés à base de fluorure de vinylidène (VDF) et de trifluoroéthylène (TrFE), pouvant éventuellement contenir un troisième monomère tel que le chlorotrifluoroéthylène (CTFE) ou le chlorofluoroéthylène (CFE).

Ces polymères sont mis en forme en tant que films, à partir d'une formulation dite « encre » constituée par une solution dans un solvant, du copolymère fluoré électroactif et, éventuellement, d'autres additifs. Lors de la fabrication de dispositifs électroactifs, il peut être nécessaire de rendre, selon un motif prédéfini, une partie ou la totalité du film insoluble. Cela est dû principalement au fait que le film de copolymère fluoré électroactif ne constitue qu'une couche de l'ensemble du dispositif. Ainsi, d'autres couches à poser sur la couche du copolymère fluoré électroactif pourront devoir être déposées dessus par voie solvant, avec le risque, si le copolymère fluoré électroactif n'est pas réticulé, qu'il se trouve partiellement ou complètement dissous (et donc détérioré) par le solvant présent dans la, ou les couches déposées sur lui.

Des polymères fluorés réticulés sont donc requis pour former la couche de copolymère électroactif dans un dispositif électroactif.

Le document WO 2015/128337 décrit des compositions réticulables comprenant un polymère fluoré électroactif et un réticulant acrylique. Ledit polymère fluoré (polymère (FC)) est réticulable en raison de la présence d'unités récurrentes dérivées d'au moins un monomère hydrogéné fonctionnalisé (monomère H'_{F}) comprenant des chaînes latérales pendantes comprenant des groupes terminaux de type éther insaturés. Les compositions réticulables décrites ici sont réticulées grâce à la présence de ces polymères fluorés réticulables.

Le document WO 2013/087500 décrit aussi des copolymères fluorés VDF-TrFE rendus réticulables par la copolymérisation de monomères comprenant des groupes azide, avec les monomères de base VDF et TrFE, lesdits copolymères fluorés ainsi obtenus pouvant être réticulés par voie thermique ou par irradiation UV.

Une autre solution a été proposée dans le document US 6,680,357 qui décrit des compositions réticulables comprenant des copolymères à base de VDF et d'hexafluoropropylène (HFP) à modification acrylique obtenus par polymérisation desdits copolymères fluorés avec des monomères acryliques.

Dans ces cas de figure, il est indispensable de modifier chimiquement au préalable le copolymère fluoré électroactif, ce qui rajoute une étape au procédé de préparation du polymère réticulé, avec le risque de dégrader les performances initiales du copolymère fluoré électroactif.

D'autres stratégies prévoient la réticulation directe du copolymère fluoré électroactif par voie radicalaire (peroxydes) ou par réaction avec des diamines, ou encore par faisceau d'électrons ou par rayons X ; elles présentent toutefois l'inconvénient d'une modification, souvent chimiquement non souhaitable, du copolymère fluoré électroactif, pouvant entraîner une perte de ses propriétés.

Ainsi, il existe un besoin de disposer de copolymères fluorés électroactifs qui conservent, après réticulation de la composition qui les englobe, leurs propriétés électroactives, notamment leur constante diélectrique ou leur polarisation, mais aussi mécaniques, de sorte à fournir un comportement optimal lors de leur utilisation dans un dispositif (opto)électronique, ceci sans que ces polymères fluorés réticulent eux-mêmes, ni qu'ils soient rendus réticulables par copolymérisation avec des comonomères pouvant constituer des unités répétitives réactives vis-à-vis de la réticulation, ou par modification chimique créant sur le polymère des sites réactifs vis-à-vis de la réticulation.

### RESUME DE L'INVENTION

L'invention est selon les revendications annexées.

Un premier objectif de l'invention est de proposer une composition réticulable consistant en :
a) au moins un copolymère fluoré électroactif de formule générale P(VDF-TrFE) ou de formule générale P(VDF-TrFE-X), dans lesquelles VDF représente des unités issues du fluorure de vinylidène, TrFE représente des unités issues du trifluoroéthylène et X représente des unités issues d'un tiers monomère porteur d'au moins un atome de fluor,
b) au moins un monomère (méth)acrylique bi ou polyfonctionnel en termes de doubles liaisons réactives,
c) au moins un amorceur de polymérisation radicalaire,
d) au moins un solvant organique, et
e) au moins un additif choisi dans la liste: autres monomères (méth)acryliques qui sont monofonctionnels en termes de double liaisons réactives, agents modifiants de la tension superficielle, de la rhéologie, de la tenue au vieillissement, de l'adhésion ou de la couleur, des charges et des nanocharges.

Le copolymère fluoré électroactif n'est pas apte à une polymérisation et/ou une réticulation après activation de l'amorceur de polymérisation radicalaire. L'au moins un monomère (méth)acrylique bi-ou polyfonctionnel étant apte à une polymérisation et réticulation initiée après activation de l'amorceur de polymérisation radicalaire pour former un réseau méthacrylique au sein d'une structure copolymère fluoré électroactif-réseau réticulé méthacrylique.

Selon un mode de réalisation, ledit copolymère fluoré électroactif est un copolymère de formule générale P(VDF-TrFE), dans laquelle VDF représente des unités issues du fluorure de vinylidène et TrFE représente des unités issues du trifluoroéthylène.

Selon un mode de réalisation, le rapport molaire des unités VDF sur les unités TrFE dans le polymère vaut de 50:50 à 85:15.

Selon un mode de réalisation, ledit copolymère fluoré électroactif est un terpolymère de formule générale P(VDF-TrFE-X), dans laquelle VDF représente des unités issues du fluorure de vinylidène, TrFE représente des unités issues du trifluoroéthylène, et X représente des unités issues d'un tiers monomère porteur d'au moins un atome de fluor qui peut notamment être choisi le tétrafluoroéthylène (TFE), le chlorofluoroéthylène (CFE), le chlorotrifluoréthylène (CTFE), l'hexafluoropropylène (HFP), le 3,3,3-trifluoropropène, le 1,3,3,3-tétrafluoropropène (ou 1234ze), le 2,3,3,3-tétrafluoropropène (ou 1234yf), le 3-chloro-2,3,3-trifluoropropène (ou 1233yf), le 2-chloro-3,3,3-trifluoropropène (ou 1233xd), l'hexafluoroisobutylène, le perfluorobutyléthylène, le pentafluoropropène et leurs mélanges. De préférence, lorsqu'il est présent, ledit tiers monomère est choisi parmi le CFE et le CTFE.

Selon un mode de réalisation, la proportion molaire d'unités X dans le polymère vaut de 0,1 à 15 %, de préférence de 0,5 à 13 %, et de manière plus particulièrement préférée de 1 à 12 %.

Ledit monomère (méth)acrylique bi ou polyfonctionnel en termes de doubles liaisons réactives peut être un monomère ou un oligomère (méth)acrylique bi ou polyfonctionnel. S'agissant de monomères utiles à l'invention, on peut citer les monomères et oligomères contenant au moins deux double liaisons réactives de type (méth)acryliques.

Un autre objet de l'invention concerne un film réticulé constitué d'un copolymère fluoré électroactif et d'un copolymère (méth)acrylique réticulé, ledit film étant obtenu à partir de la composition réticulable selon l'invention. De manière caractéristique, ledit copolymère fluoré n'est pas réticulé, et reste ainsi non-modifié chimiquement, ni par copolymérisation avec des comonomères pouvant constituer des unités répétitives réactives vis-à-vis de la réticulation, ni par modification chimique créant sur le polymère des sites réactifs vis-à-vis de la réticulation.

Un autre objectif de l'invention est de fournir un procédé de préparation dudit film réticulé, ledit procédé consistant en :
- fournir une composition réticulable selon l'invention, comme décrit ci-dessus, dans laquelle lesdits composants (a), (b), et (c) et (e) sont dissous dans ledit solvant (d) pour obtenir une encre,
- déposer ladite encre sur un support, un dispositif ou une partie d'un dispositif (opto)électronique pour former un film,
- sécher ledit film par évaporation partielle ou totale du solvant, et
- réticuler tout ou une partie, selon un motif prédéfini, dudit film par polymérisation du (ou des) monomères (méth)acryliques.
- dans le cas de la formation souhaitée d'un motif prédéfini, développer ledit film pour retirer les parties non-réticulées.

L'invention a trait également aux dispositifs (opto)électroniques comprenant, comme couche électroactive, au moins une couche du film préparé selon le procédé sus mentionné.

La présente invention rend possible de surmonter les inconvénients de l'art antérieur. En particulier, l'invention permet d'obtenir des films réticulés dans lesquels les polymères électroactifs restent non-modifiés, car ce qui forme un réseau réticulé est la partie (méth)acrylique qui polymérise et réticule après activation de l'amorceur radicalaire. De ce fait, et sans que cela constitue une limitation de l'invention on peut penser que les films selon l'invention sont constitués d'un réseau de deux polymères (fluoré et (méth)acrylique) dit réseau semi-interpénétré ou semi-IPN, dans lequel la composante fluorée n'est pas réticulée et reste donc peu affectée du point de vue des propriétés électriques. Le réseau (méth)acrylique, lui, est réticulé et assure la tenue aux solvants de l'ensemble. Autrement dit, l'invention fournit un film réticulé qui comprend un réseau réticulé acrylique au sein d'un système polymère fluoré non-réticulé, les deux systèmes étant chimiquement indépendants. De manière surprenante, ce système mixte polymère fluoré non-réticulé / polymère acrylique réticulé permet d'obtenir un comportement de résistance aux solvants. Cette stratégie permet l'empilement de couches d'un dispositif (opto)électronique par-dessus la couche comprenant le copolymère fluoré électroactif, sans que les solvants de ces nouvelles couches viennent dissoudre ou détériorer la couche de copolymère électroactif fluoré. Cette stratégie permet également de réaliser des motifs prédéfinis de la couche de copolymères fluoré électroactif pour la réalisation de dispositifs (opto)électroniques complexes.

L'utilisation de copolymères fluorés électroactifs composés de VDF, de TrFE et éventuellement d'un troisième monomère porteur d'atomes de fluor permet d'optimiser les propriétés électroactives du copolymère. En effet, ces propriétés électroactives proviennent de la présence de nombreuses liaisons carbone-fluor (C-F) fortement polarisées, c'est-à-dire avec une densité électronique fortement déplacée sur l'atome de fluor. L'utilisation de monomères non-porteurs d'atomes de fluor pour la synthèse des copolymères fluorés électroactifs tels que les monomères (méth)acryliques comme l'acide (méth)acrylique, diminue le nombre de liaisons C-F présentes le long de la chaîne polymère. Une diminution des propriétés électroactives est donc attendue.

Par ailleurs, l'utilisation de lumière UV pour amorcer la réticulation présente un avantage important en termes de création de motifs (« patterning », selon le terme en anglais), car on peut irradier sélectivement certaines zones pour les réticuler et les rendre insolubles, alors que d'autres ne le sont pas. Un traitement ultérieur par un solvant de développement (« solvent-etching ») permet de dissoudre les parties non irradiées, ce qui conduit à la création de motifs ou « patterns ».

De plus, en comparaison avec la chimie des azides, comme dans la demande WO 2013/087500 la dose UV nécessaire pour obtenir la réticulation est plus faible que celle nécessaire pour les bis-azides. Cela permet d'éviter la dégradation des propriétés d'un dispositif multi-couche contenant des couches photosensibles.

### BREVE DESCRIPTION DES FIGURES

La **Figure 1** représente un spectrogramme infrarouge des films formés à partir des formulations 0 (bas, ligne continue) et 7 (haut, ligne brisée) en utilisant la butan-2-one comme solvant et le copolymère P(VDF-TrFE) comme copolymère fluoré électroactif.
La **Figure 2** représente un spectrogramme infrarouge des films formés à partir des formulations 0 (bas, ligne continue) et 7 (haut, ligne brisée) en utilisant la butan-2-one comme solvant et le copolymère P(VDF-TrFE-CTFE) comme copolymère fluoré électroactif.

### DESCRIPTION DE MODES DE REALISATION

L'invention sera maintenant décrite plus en détail sans limitation dans la description suivante.

Le problème technique que la présente invention se propose à résoudre consiste en devoir rendre, après sa mise en place sur un support, ou un dispositif, une couche (un film) de copolymère fluoré électroactif utile dans la fabrication de certains dispositifs (opto)électroniques, insensible à l'attaque de certains solvants de manière à éviter sa dissolution ou dégradation lors du dépôt par voie solvant d'autres couches organiques ou inorganiques faisant partie du dispositif et étant déposées postérieurement au dépôt de la couche de copolymère fluoré électroactif. Un autre problème technique que la présente invention se propose de résoudre est celui de la création de motifs (« patterns ») après dépôt sur une surface d'un film de copolymère fluoré électroactif sur un support ou un dispositif. Ces problèmes sont résolus par la composition réticulable décrite ci-après.

L'invention concerne, selon un premier aspect, une composition réticulable consistant en:
a) au moins un copolymère fluoré électroactif de formule générale P(VDF-TrFE) ou de formule générale P(VDF-TrFE-X), dans lesquelles VDF représente des unités issues du fluorure de vinylidène, TrFE représente des unités issues du trifluoroéthylène et X représente des unités issues d'un tiers monomère porteur d'au moins un atome de fluor,
b) au moins un monomère (méth)acrylique bi ou polyfonctionnel en termes de doubles liaisons réactives,
c) au moins un amorceur de polymérisation radicalaire,
d) au moins un solvant organique, et
e) au moins un additif choisi dans la liste: autres monomères (méth)acryliques qui sont monofonctionnels en termes de double liaisons réactives, agents modifiants de la tension superficielle, de la rhéologie, de la tenue au vieillissement, de l'adhésion ou de la couleur, des charges et des nanocharges.

Selon un mode de réalisation, ledit copolymère fluoré électroactif est un copolymère de formule générale P(VDF-TrFE), dans laquelle VDF représente des unités issues du fluorure de vinylidène et TrFE représente des unités issues du trifluoroéthylène.

Selon un mode de réalisation, le rapport molaire des unités VDF sur les unités TrFE dans le polymère vaut de 50:50 à 85:15.

Selon un mode de réalisation, ledit copolymère fluoré électroactif est un terpolymère de formule générale P(VDF-TrFE-X), dans laquelle VDF représente des unités issues du fluorure de vinylidène, TrFE représente des unités issues du trifluoroéthylène, et X représente des unités issues d'un tiers monomère porteur d'au moins un atome de fluor qui peut notamment être choisi parmi : le tétrafluoroéthylène (TFE), le chlorofluoroéthylène (CFE), le chlorotrifluoréthylène (CTFE), l'hexafluoropropylène (HFP), le 3,3,3-trifluoropropène, le 1,3,3,3-tétrafluoropropène (ou 1234ze), le 2,3,3,3-tétrafluoropropène (ou 1234yf), le 3-chloro-2,3,3-trifluoropropène (ou 1233yf), le 2-chloro-3,3,3-trifluoropropène (ou 1233xd), l'hexafluoroisobutylène, le perfluorobutyléthylène, le pentafluoropropène et leurs mélanges. De préférence, lorsqu'il est présent, ledit tiers monomère est choisi parmi le CFE et le CTFE.

Selon un mode de réalisation, la proportion molaire d'unités X dans le polymère vaut de 0,1 à 15 %, de préférence de 0,5 à 13 %, et de manière plus particulièrement préférée de 1 à 12 %.

Le copolymère fluoré électroactif (a) peut être homogène ou hétérogène, ou un mélange de copolymères homogènes et hétérogènes. Un polymère homogène présente une structure de chaînes uniforme, la répartition statistique des comonomères ne variant pas entre les chaînes polymères. Dans un copolymère hétérogène, les chaînes polymères présentent une distribution en teneur moyenne en comonomères de type multimodale ou étalée : il comprend donc des chaînes polymères riches en un comonomère et des chaînes polymères pauvres en ledit comonomère. Un exemple de PVDF hétérogène figure dans le document WO 2007/080338.

Bien que des polymères P(VDF-TrFE) et P(VDF-TrFE-X) puissent être produits en utilisant tout procédé connu, tel que la polymérisation en émulsion, la polymérisation en suspension et la polymérisation en solution, il est préférable d'utiliser le procédé décrit dans WO 2010/116105. Ce procédé permet d'obtenir des polymères de poids moléculaire élevé et de structuration adaptée.

En bref, le procédé préféré pour la préparation du polymère P(VDF-TrFE-X) comprend les étapes suivantes :
- le chargement d'un mélange initial de VDF et de TrFE (sans X) dans un autoclave agité contenant de l'eau ;
- le chauffage de l'autoclave à une température prédéterminée, proche de la température de polymérisation ;
- l'injection d'un amorceur de polymérisation radicalaire mélangé avec de l'eau dans l'autoclave, afin d'atteindre une pression dans l'autoclave qui est de préférence d'au moins 80 bar, afin de former une suspension des monomères de VDF et de TrFE dans de l'eau ;
- l'injection d'un second mélange de VDF, TrFE et X dans l'autoclave ;
- dès que la réaction de polymérisation démarre, l'injection continue dudit second mélange dans le réacteur autoclave, afin de maintenir la pression à un niveau essentiellement constant de préférence d'au moins 80 bar.

L'amorceur de polymérisation radicalaire peut être un peroxyde organique tel qu'un peroxydicarbonate. Il est généralement utilisé en une quantité de 0,1 à 10 g par kilogramme du chargement total de monomères. De préférence, la quantité utilisée est de 0,5 à 5 g/kg.

Le mélange initial comprend avantageusement uniquement du VDF et du TrFE en une proportion égale à celle du polymère final souhaité.

Le second mélange a avantageusement une composition qui est ajustée de manière à ce que la composition totale de monomères introduite dans l'autoclave, y compris le mélange initial et le second mélange, soit égale ou approximativement égale à la composition du polymère final souhaité.

Le rapport en poids entre le second mélange et le mélange initial est de préférence de 0,5 à 2, de manière davantage préférée de 0,8 à 1,6.

La mise en œuvre de ce procédé avec un mélange initial et un second mélange rend le procédé indépendant de la phase d'initiation de la réaction, qui est souvent imprévisible. Les polymères ainsi obtenus sont sous la forme d'une poudre, sans croûte ou peau.

La pression dans le réacteur autoclave est de préférence de 80 à 110 bar, et la température est maintenue à un niveau de préférence de 40 °C à 60 °C.

Le second mélange est injecté en continu dans l'autoclave. Il peut être comprimé avant d'être injecté dans l'autoclave, par exemple en utilisant un compresseur ou deux compresseurs successifs, généralement à une pression supérieure à la pression dans l'autoclave.

Bien que, selon certains modes de réalisation, des monomères supplémentaires puissent être utilisés en tant que matériaux de départ (en une quantité minoritaire, telle que par exemple inférieure à 5 % ou inférieure à 2 % ou inférieure à 1 %) et que le polymère de l'invention résultant puisse par conséquent comprendre une quantité minoritaire (telle que par exemple inférieure à 5 % ou inférieure à 2 % ou inférieure à 1 %) d'autres unités structurales que celles citées précédemment, seuls des monomères de VDF, TrFE et X sont de préférence utilisés en tant que matériaux de départ, de manière à ce que le polymère soit composé uniquement de VDF et TrFE ou de VDF, TrFE et X.

Toutefois, selon un mode de réalisation préféré, un seul type de monomère X est utilisé, et le polymère de l'invention est donc de préférence un terpolymère constitué exclusivement d'unités VDF, d'unités TrFE et d'unités X d'un seul type.

Après synthèse, le polymère est lavé et séché.

La masse molaire moyenne en poids Mw du copolymère fluoré électroactif (a) est de préférence d'au moins 100 000, de préférence d'au moins 200 000 et de manière davantage préférée d'au moins 300 000 ou d'au moins 400 000. Elle peut être ajustée par modification de certains paramètres du procédé, tels que la température dans le réacteur, ou par ajout d'un agent de transfert.

La distribution en masses molaires peut être estimée par SEC (chromatographie d'exclusion stérique) dans le diméthylformamide (DMF) en tant qu'éluant, avec un ensemble de 3 colonnes de porosité croissante. La phase stationnaire est un gel de styrène-DVB. Le procédé de détection est fondé sur une mesure de l'indice de réfraction, et l'étalonnage est réalisé avec des étalons de polystyrène. L'échantillon est mis en solution à 0,5 g/L dans du DMF et filtré sur un filtre en nylon de 0,45 µm.

La masse molaire peut également être estimée par mesure de l'indice de fluidité à 230 °C sous une charge de 5 ou 10 kg selon ASTM D1238 (ISO 1133).

Par ailleurs, la masse molaire peut également être caractérisée par une mesure de la viscosité en solution selon ISO 1628. La méthyléthylcétone (MEK) est un solvant préféré des copolymères et terpolymères pour la détermination de l'indice de viscosité.

Plus généralement, la composition molaire des terpolymères de l'invention peut être déterminée par divers moyens. Les méthodes classiques d'analyse élémentaire en éléments carbone, fluor et chlore ou brome conduisent à un système de deux ou trois équations indépendantes à deux inconnues indépendantes (% VF2 et % TrFE, avec % X = 100 - (% VF2 + % TrFE)), qui permet de calculer sans ambiguïté la composition massique des polymères, d'où l'on déduit la composition molaire.

On peut également mettre en œuvre les techniques de RMN multi-noyaux, ici proton (¹H) et fluor (¹⁹F), par analyse d'une solution du polymère dans un solvant deutéré approprié. Le spectre RMN est enregistré sur un spectromètre RMN-FT équipé d'une sonde multi-nucléaire. On repère alors les signaux spécifiques donnés par les différents monomères dans les spectres réalisés selon l'un ou l'autre noyau. Ainsi, l'unité TrFE (CFH=CF₂) donne en RMN du proton un signal spécifique caractéristique des H du groupement CFH (à environ 5 ppm). Il en est de même pour les H du groupement CH₂ du VF₂ (massif centré à 3 ppm). L'intégration relative des deux signaux donne l'abondance relative des deux monomères, c'est-à-dire le rapport molaire VDF / TrFE.

Les copolymères selon l'invention sont statistiques et linéaires.

Avantageusement, le copolymère fluoré électroactif (composant (a)) est un polymère thermoplastique peu ou pas élastomérique (par opposition à un fluoroélastomère). Les polymères fluorés contenant une proportion élevée d'unités issues du comonomère VDF ont tendance à être thermoplastiques et non élastomériques.

Les copolymères utilisés selon l'invention satisfont en outre de préférence à au moins un critère qui les qualifie comme des polymères électroactifs, en particulier ils présentent une température de Curie comprise entre 0 et 150 °C, de préférence entre 10 et 140 °C.

Leur température de fusion est généralement comprise entre 90 et 180 °C, plus particulièrement entre 100 et 170 °C.

Les copolymères fluorés électroactifs utilisés selon l'invention possèdent une constante diélectrique, à 25 °C et à 1 kHz, supérieure à 10, de préférence supérieure à 12.

Le deuxième composant (b) de la composition réticulable selon l'invention est un monomère (méth)acrylique bi ou polyfonctionnel en termes de doubles liaisons réactives. La composition réticulable peut contenir un ou plusieurs monomères de ce type.

Ledit monomère (méth)acrylique bi ou polyfonctionnel en termes de doubles liaisons réactives peut être un monomère ou un oligomère (méth)acrylique bi ou polyfonctionnel. S'agissant de monomères utiles à l'invention, on peut citer les monomères et oligomères contenant au moins deux double liaisons réactives de type (méth)acryliques. Ce sont ces doubles liaisons réactives qui, à l'aide d'un amorceur de polymérisation radicalaire permettront la polymérisation et réticulation du réseau (méth)acrylique au sein de la structure [copolymère fluoré électroactif - réseau réticulé (méth)acrylique]. De ce fait, tout monomère purement (méth)acrylique bi ou polyfonctionnel tel que, par exemple le dodécane diméthacrylate est utile à l'invention.

Le plus souvent, cependant, les monomères ou oligomères (méth)acryliques ont des structures chimiques dérivées des fonctions autres que la pure chimie des alcanes, tels que des diols, triols ou polyols, polyesters, éthers, polyéthers, polyuréthane, époxys, cyanurates ou iso-cyanurates. Pourvu que dans leur structure chimique, de ce fait mixte (non purement de nature hydrocarbonnée : de type alcane), ces monomères comportant au moins deux fonctions (méth)acryliques réactives en polymérisation radicalaire, ils deviennent utiles pour l'invention. On peut ainsi, citer, par exemple 1,3-butylène glycol di(méth)acrylate, butanediol di(méth)acrylate, 1,6-hexanediol di(méth)acrylate, hexanediol alkoxylé di(méth)acrylate, néopentyl glycol alkoxylé di(méth)acrylate, dodécyl di(méth) acrylate, cyclohexane diméthanol di(méth)acrylate, diéthylène glycol di(méth)acrylate, dipropylène glycol di(méth)acrylate, les alcanes linéaires di(méth) acrylate, bisphénol A éthoxylé di(méth)acrylate, éthylène glycol di(méth)acrylate, néopentyl glycol di(méth)acrylate, tricyclodécane diméthanol diacrylate, triéthylène glycol di(méth)acrylate, tétraéthylène glycol di(méth)acrylate, tripropylène glycol di(méth)acrylate, ditriméthylolpropane tétra(méth)acrylate, pentaérythritol éthoxylé tétra(méth)acrylate, dipentaérythritol penta(méth)acrylate, penta(méth)acrylate ester, pentaérythritol tétra(méth)acrylate, triméthylolpropane éthoxylé tri(méth)acrylate, triméthylolpropane alkoxylé tri(méth)acrylate, triméthylolpropane tri(méth)acrylate, pentaérythritol tri(méth)acrylate, triméthylolpropane propoxylé tri(méth)acrylate, triméthylolpropane triméthacrylate, dodécanediol di(méth)acrylate, dodécane di(méth)acrylate, dipentaérythritol penta/hexa(méth)acrylate, pentaérythritol tetra(méth)acrylate, di-triméthylolpropane tétra(méth)acrylate, glyceryl propoxylé tri(méth)acrylate, glycéryl propoxylé tri(méth)acrylate, tris (2-hydroxy éthyl) isocyanurate tri(méth)acrylate, polyesters (méth)acrylates, polyéthers (méth)acrylates, polyéthylènes glycol (méth)acrylates, polypropylènes glycol (méth)acrylates, polyuréthanes (méth)acrylates, epoxy (méth)acrylates, et les combinaisons de ceux-ci.

De préférence, on peut choisir le monomère ou l'oligomère bi ou polyfonctionnel (méth)acrylique parmi : triméthylolpropane triacrylate (comme celui commercialisé par la société Sartomer sous la référence SR351), triméthylolpropane triacrylate ethoxylé (comme celui commercialisé par la société Sartomer sous la référence SR454), uréthane aliphatique modifié polyacrylate (comme celui commercialisé par la société Sartomer sous la référence CN927).

La composition réticulable selon l'invention contient aussi au moins un amorceur de polymérisation radicalaire (composant (c)). L'amorceur de réticulation est choisi parmi le 2-hydroxy-2-méthyl-1-phenyl-propan-1-one, 2,4,6-triméthylbenzoyl-diphenyl-phosphineoxide, 2,4,6-trimethylbenzoylphenyl phosphinate, 1-hydroxy-cyclohexyl-phenyl-cétone, bis(2,6-diméthoxybenzoyl)-2,4,4-triméthyl-pentyl phosphine oxyde, 1-[4-(2-hydroxyéthoxy)-phenyl]-2-hydroxy-2-méthyl-1-propane-1-one, 2,2-diméthoxy-1,2-diphenyléthan-1-one et le 2-méthyl-1[4-(méthylthio)phenyl]-2-morpholinopropan-1-one, 2,4-diethylthioxanthone, leurs dérivés, et mélanges de ceux-ci.

A titre de solvant (d) pour la fabrication d'une solution, on utilise un solvant ou un mélange de solvants choisi parmi ceux capables de dissoudre le ou les copolymères fluorés électroactifs, le ou les monomères (méth)acryliques (b) et le ou les amorceurs de polymérisation, de préférence de manière homogène, pour former, de préférence, une solution transparente. On peut citer en particulier : les cétones, par exemple, l'acétone, la méthyl éthyl cétone, la méthyl isobutyl cétone, la cyclo pentanone ; les furanes, par exemple le tétrahydrofurane ; les esters, par exemple l'acétate de méthyle, l'acétate d'éthyle, l'acétate de propyle, l'acétate de butyle ou l'acétate de propylène glycol méthyl éther (PGMEA) ; les carbonates, par exemple le diméthylcarbonate ; les amides telles que le diméthylformamide et le diméthylacétamide ; et les solvants sulfoxydes comme le diméthylsulfoxyde.

Le cinquième et dernier composant de la composition réticulable selon l'invention est représenté par les additifs (composant (e)), choisis dans la liste: autres monomères (méth)acryliques qui sont monofonctionnels en termes de double liaisons réactives, agents modifiants de la tension superficielle, de la rhéologie, de la tenue au vieillissement (tels que des additifs anti-UV de type organique tels que l'hydroxybenzophénone ou l'hydroxyphénylbenzotriazole ou de type inorganique tels que le TiO₂), de l'adhésion (tels que des molécules, ou des oligomères ou des polymères porteurs de groupements associatifs pouvant être des acides faibles tels que des acides carboxyliques, -COOH ou phosphoniques, -P(O)(OH)₂) ou de la couleur (tels que des pigments de type organiques tels que les phtalocyanines, les anthraquinone ou de type inorganiques tels que des complexes de fer, cuivre, de manganèse, chrome), des charges (telles que le TiO₂, le CaCO₃, des argiles et des zéolites de taille micrométriques) et des nanocharges (argiles et zéolites de tailles nanométrique, nanotubes de carbone). Ces additifs sont destinés à améliorer les propriétés de la composition en tant qu'encre ou du film formé à partir de cette encre. Des additifs préférés sont notamment les co-solvants modificateurs de la tension superficielle et/ou de la rhéologie de l'encre. En particulier, il peut s'agir, dans le cas des solutions, de composés organiques miscibles aux solvants utilisés. La composition d'encre peut également contenir un ou des additifs ajoutés pour améliorer une propriété de l'encre, telle que sa mouillabilité de la surface du dispositif électronique, par exemple, ou son adhésion à cette surface par exemple.

Avantageusement, la solution selon l'invention ne contient pas de composés porteurs d'une fonction azide (N₃). Les composés porteurs de fonctions azides sont souvent explosifs et toxiques selon l'article de H. C. Kolb et al. ; Angew. Chem. Int. Ed., 2001, 40, 2004 - 2021.

Selon un mode de réalisation, dans la composition réticulable selon l'invention :
i. le copolymère fluoré électroactif (a) constitue entre 60% et 99,99% en poids, et de préférence entre 70% et 99% en poids de la somme constituée par les poids des composants (a) et (b),
ii. l'amorceur radicalaire (c) constitue entre 0,1% et 10% en poids et de préférence entre 0,2% et 5% en poids de la somme constituée par les poids des composants (a), (b) et (c),
iii. les additifs (e) constituent de 0,01% jusqu'à moins de 20% en poids du poids de la composition.

La composition réticulable selon l'invention comprend entre 0,5% en poids et 60% en poids de matière sèche non volatile, et de préférence entre 1% en poids et 30% en poids de matière sèche non volatile.

Selon un deuxième aspect, l'invention concerne un film réticulé constitué d'un copolymère fluoré électroactif et d'un copolymère (méth)acrylique réticulé. De manière caractéristique, ledit copolymère fluoré n'est pas réticulé, et reste ainsi non-modifié chimiquement, ni par copolymérisation avec des comonomères pouvant constituer des unités répétitives réactives vis-à-vis de la réticulation, ni par modification chimique créant sur le polymère des sites réactifs vis-à-vis de la réticulation. Dans cette approche, des monomères acryliques poly(fonctionnels) sont mis en intime mélange avec le polymère fluoré électroactif (ce qui est obtenu en passant par la voie encres (solution)), lesdits monomères étant par la suite polymérisés et réticulés entre eux. Dans le film réticulé selon l'invention, et à la différence de l'art antérieur, l'ingrédient polymère fluoré n'est pas modifié chimiquement pour créer sur le polymère fluoré, lui-même, des sites de réticulation.

Selon un troisième aspect, l'invention concerne un procédé de préparation dudit film réticulé, ledit procédé consistant en les étapes successives suivantes :
- fournir une composition réticulable selon l'invention, comme décrit ci-dessus, dans laquelle lesdits composants (a), (b), (c) et (e) sont dissous dans ledit solvant (d) pour obtenir une encre,
- déposer ladite encre sur un support, un dispositif ou une partie d'un dispositif (opto)électronique pour former un film,
- sécher ledit film par évaporation partielle ou totale du solvant, et
- réticuler toute ou une partie dudit film par polymérisation du (ou des) monomères (méth)acryliques.
- dans le cas de la formation souhaitée d'un motif prédéfini, développer ledit film pour retirer les parties non-réticulées.

Selon un mode de réalisation, l'amorceur radicalaire est un photo-amorceur susceptible d'activer un amorçage radicalaire via l'irradiation de la couche d'encre déposée et « séchée » (évaporation partielle ou totale du solvant) par de la lumière partiellement ou complètement composée des tranches spectrales tombant dans le domaine des ultraviolets, c'est-à-dire, par de la lumière dont une partie ou la totalité se trouve dans la gamme spectrale comprise entre 150 et 410 nm de longueur d'onde. De préférence, l'activation de l'amorceur est obtenue par une irradiation comprenant les longueurs d'onde dans le domaine des UVA dans la gamme spectrale comprise entre 315 et 410 nm. De préférence, l'activation de l'amorceur est obtenue avec une irradiation comprenant les longueurs d'onde à 365 nm et/ou à 385 nm et/ou à 405 nm. De préférence aussi, la dose irradiante pour provoquer la réticulation est inférieure à 20 J/cm² et de préférence encore, inférieure à 10 J/cm². Cette dose est plus faible que celle nécessaire pour les bis-azides.

Cela permet d'éviter la dégradation des propriétés d'un dispositif multi-couches contenant des couches photosensibles.

Enfin, l'invention consiste également en l'utilisation de la couche (film) de copolymère électroactif au sein d'un dispositif (opto)électronique, en tant que couche diélectrique, par exemple, à haute permittivité électrique de faible épaisseur pour permettre la fabrication de transistors à effets de champs, de mémoires ferroélectriques notamment dans le secteur de l'électronique organique imprimée. La couche de copolymère fluoré électroactif réticulée à faible ou haute permittivité électrique peut également être utilisée dans les domaines de la fabrication de mémoires, capacités, capteurs, actionneurs, microsystèmes électromécaniques, dispositifs haptiques et condensateurs.

On entend par dispositif électronique soit un composant électronique unique, soit un ensemble de composants électroniques, susceptible(s) de remplir une ou des fonctions dans un circuit électronique.

De préférence, dans le cadre de l'invention, le dispositif électronique est plus particulièrement un dispositif optoélectronique, c'est-à-dire susceptible d'émettre, de détecter ou de contrôler un rayonnement électromagnétique.

Des exemples de dispositifs électroniques, ou le cas échéant optoélectroniques, concernés par la présente invention sont les transistors, les puces, les batteries, les cellules photovoltaïques, les diodes électroluminescentes (LED), les diodes électroluminescentes organiques (OLED), les capteurs, les actionneurs, les transformateurs et les détecteurs.

Les dispositifs électroniques et optoélectroniques sont utilisés et intégrés dans de nombreux appareils, équipements ou sous-ensembles électroniques et dans de nombreux objets et applications tels que les téléviseurs, les téléphones portables, les écrans rigides ou flexibles, les modules photovoltaïques à couches minces, les sources d'éclairage, les capteurs et convertisseurs d'énergie, etc.

Dans le dispositif selon l'invention, ladite couche de film a une épaisseur inférieure à 100 µm, de préférence inférieure à 80 µm. Dans certains dispositifs selon l'invention tels que les mémoires ou les transistors, ladite couche de film peut avoir une épaisseur inférieure à 1 µm.

La rugosité de surface de la couche de polymère fluoré (mesurée avec un profilomètre) est de préférence inférieure ou égale à 20 nm (en Ra, moyenne quadratique), et plus particulièrement inférieure ou égale à 10 nm et de manière encore plus préférée, inférieure ou égale à 7 nm. Cette rugosité de surface peut être déterminée par une mesure de topographie de surface avec un profilomètre de type alpha-step IQ.

### EXEMPLES

Les exemples suivants illustrent l'invention sans la limiter. Ils décrivent la formulation d'un polymère fluoré électroactif à base de VDF et de TrFE, dans un solvant, avec un ou des photo-amorceurs et des monomères (méth)acryliques bi ou polyfonctionnels permettant la réticulation, ainsi que des additifs tels que des monomères (méth)acryliques monofonctionnels. L'efficacité de la solution technique apportée est évaluée par l'étude de la solubilité dans le solvant utilisé pour la formulation du film après irradiation UV. Un film est dit réticulé lorsqu'il est insoluble dans le solvant. Des mesures de constantes diélectriques sont aussi réalisées.

### Exemple 1 :

### Préparation de la formulation.

La poudre de polymère fluoré électroactif est dissoute dans la butan-2-one (MEK) pour former une solution à 14 % en masse. A cette solution, le(s) photo-amorceur(s), le(s) monomère(s) (méth)acryliques(s) bi ou polyfonctionnels et d'autres monomères monofonctionnels (additifs) sont ajoutées. La formulation est homogénéisée par agitation mécanique pendant 10 minutes à température ambiante.

### Préparation du film.

Le film de polymère est préparé en appliquant la solution précédemment préparée sur une plaque de verre. Le film est séché pendant 1 h à température ambiante puis 30 minutes à 60 °C dans une étuve ventilée.

### Réticulation du film.

Le film, d'une épaisseur comprise entre 11-12 µm, est irradié par une lampe UV LED pendant 15 secondes.

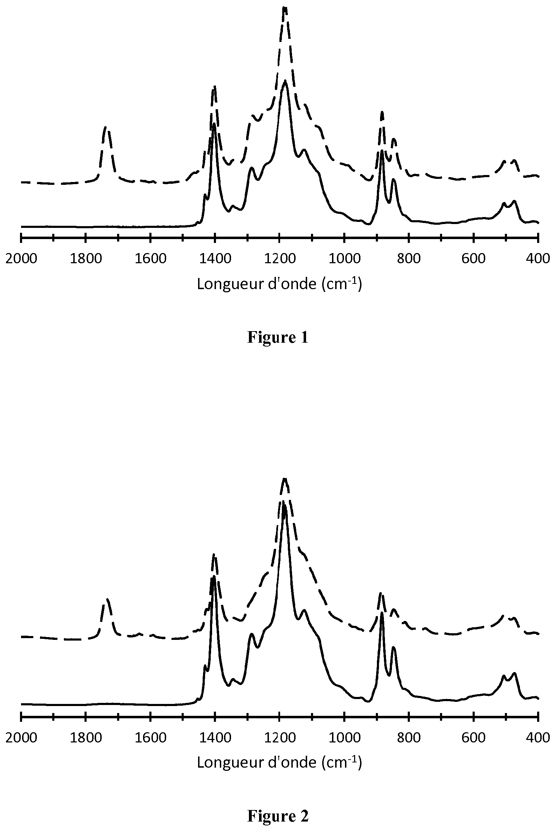

Les figures 1 et 2 présentent des spectres infrarouges de films. Pour les films réticulés à partir de la formulation 7, on observe à 1750 cm-1 la bande de vibration de valence caractéristique du motif carbonyle de l'acrylate. De plus, les bandes caractéristiques des conformations tttg+tttg- et all-trans liées aux propriétés électroactives des polymères sont toujours observées à 1250 et 850 cm-1.

Le Tableau 1 ci-dessous illustre l'influence de la composition de formulations dans la butan-2-one.

**Tableau 1**

| Formulation | 0 | 1 | 2 | 3 | 4 | 5 | 6 | 7 | 8 |
|---|---|---|---|---|---|---|---|---|---|
| Polymère fluoré électroactif^{a} | 10 0 | 98, 5 | 78,5 | 78,5 | 78,5 | 78,5 | 88,5 | 78,5 | 68,5 |
| Photo-amorceur | - | Irgacure TPO-L 1% + SpeedCure DETX 0,5% | | | | | | | |
| Monomère (méth)acrylique bi ou polyfonctionnel | - | - | | SR35 1 10% | SR45 4 10% | CN92 7 20% | SR35 1 10% | SR35 120% | SR35 1 30 % |
| Monomère (méth)acrylique monofonctionn el (additif) | | | SR28 5 20% | SR28 5 10% | SR28 5 10% | SR285 1% | SR28 5 1% | SR28 51% | SR28 5 1% |
| Solubilité dans butan-2-one (24 h à 22 °C) | OUI | OU I | OUI | NON | NON | NON | NON | NON | NON |
| Constante diélectrique ε 22 °C et 1 kHz^{b} | 28 | 25 | 24 | 17 | 20 | 18 | 19 | 19 | 15 |

| | | | | | | | | | |
|---|---|---|---|---|---|---|---|---|---|
| ^{a} Le polymère fluoré électroactif peut être : un copolymère poly(VDF-co-TrFE), un terpolymère poly(VDF-*ter*-TrFE-*ter*-CTFE) ou un terpolymère poly(VDF-*ter*-TrFE-*ter-*CFE), de compositions molaires respectives, 70/30, 62/30/8 et 61/31/8. ^{b} Les mesures ont été réalisés sur les films préparés à partir du terpolymère poly(VDF-*ter-*TrFE*-ter-*CTFE)*.* | | | | | | | | | |

0 : Formulation de référence contenant uniquement le polymère fluoré électroactif. L'irradiation UV ne dégrade pas le polymère.
1 : Influence du photo-amorceur. Sans influence sur la solubilité et les propriétés du film.
2 : Influence d'un acrylate mono-fonctionnel (additif). Il ne permet pas la réticulation.
3-8 : Influence de différentes formulations avec au minimum un (méth)acrylate bi ou poly-fonctionnel. Les films sont réticulés. La constante diélectrique reste élevée et donc satisfaisante pour les applications visées.

### Exemple 2 :

### Préparation de la formulation.

La poudre de polymère fluoré électroactif (terpolymère poly(VDF-*ter*-TrFE-*ter*-CTFE) de composition molaire 62/30/8) est dissoute dans le propylène glycol méthyl éther acétate (PGMEA) pour former une solution à 7 % en masse. A cette solution, les photo-amorceurs (Irgacure TPO-L 1% + SpeedCure DETX 0,5%), le(s) monomère(s) (méth)acryliques(s) bi ou polyfonctionnels, sont ajoutés. La formulation est homogénéisée par agitation mécanique pendant 10 minutes à température ambiante.

### Préparation du film.

Le film de polymère est préparé par un dépôt sur tournette à température ambiante (20-25 °C) sur une plaque de verre. Le film est séché pendant 3 minutes à 100 °C sur une plaque chauffante.

### Réticulation du film.

Le film, d'une épaisseur comprise entre 0,8 et 1,5 µm, est irradié par une lampe UV LED à 385 nm pendant 15 secondes.

Le Tableau 2 ci-dessous illustre l'influence de la composition de formulations (nature du composé (méth)acrylique bi ou polyfonctionnel et sa concentration) dans le PGMEA, sur la solubilité dans le PGMEA, des films fins, formés à partir de celles-ci.

**Tableau 2**

| Formulation | Monomère (méth)acrylique bi ou polyfonctionnel | % de Monomère (méth)acrylique bi ou polyfonctionnel par rapport au polymère fluoré électroactif | Solubilité dans le PGMEA (5 min à 23 °C) |
|---|---|---|---|
| 9 | CN966 H90 | 30 | OUI |
| 10 | CN981 | 30 | NON |
| 11 | CN981 | 20 | OUI |
| 12 | CN9002 | 30 | NON |
| 13 | CN9002 | 20 | OUI |
| 14 | CD561 | 30 | NON |
| 15 | CD561 | 20 | NON |
| 16 | CD561 | 10 | NON |
| 17 | SR238 | 30 | OUI |
| 18 | SR285 | 30 | OUI |
| 19 | SR351 | 30 | NON |
| 20 | SR351 | 20 | NON |
| 21 | SR351 | 10 | OUI |
| 22 | SR499 | 30 | NON |
| 23 | SR499 | 20 | NON |
| 24 | SR499 | 10 | NON |

## Revendications

1. Composition réticulable consistant en :
a) au moins un copolymère fluoré électroactif de formule générale P(VDF-TrFE) ou de formule générale P(VDF-TrFE-X), dans lesquelles VDF représente des unités issues du fluorure de vinylidène, TrFE représente des unités issues du trifluoroéthylène et X représente des unités issues d'un tiers monomère porteur d'au moins un atome de fluor,
b) au moins un monomère (méth)acrylique bi ou polyfonctionnel en termes de doubles liaisons réactives,
c) au moins un amorceur de polymérisation radicalaire,
d) au moins un solvant organique, et
e) au moins un additif choisi dans la liste: monomères (méth)acryliques monofonctionnels en termes de double liaisons réactives, agents modifiants de la tension superficielle, de la rhéologie, de la tenue au vieillissement, de l'adhésion ou de la couleur, des charges et des nanocharges ;
le copolymère fluoré électroactif n'étant pas apte à une polymérisation et/ou une réticulation après activation de l'amorceur de polymérisation radicalaire ; l'au moins un monomère (méth)acrylique bi-ou polyfonctionnel étant apte à une polymérisation et réticulation initiée après activation de l'amorceur de polymérisation radicalaire pour former un réseau méthacrylique au sein d'une structure copolymère fluoré électroactif-réseau réticulé méthacrylique.

2. Composition selon la revendication 1, dans laquelle ledit copolymère fluoré électroactif est un copolymère de formule générale P(VDF-TrFE), le rapport molaire VDF : TrFE dans le polymère allant de 50:50 à 85:15.

3. Composition selon la revendication 1, dans laquelle ledit copolymère fluoré électroactif est un terpolymère de formule générale P(VDF-TrFE-X), dans laquelle X est choisi parmi : le tétrafluoroéthylène, le chlorofluoroéthylène, le chlorotrifluoréthylène, l'hexafluoropropylène, le 3,3,3-trifluoropropène, le 1,3,3,3-tétrafluoropropène (ou 1234ze), le 2,3,3,3-tétrafluoropropène (ou 1234yf), le 3-chloro-2,3,3-trifluoropropène (ou 1233yf), le 2-chloro-3,3,3-trifluoropropène (ou 1233xd), l'hexafluoroisobutylène, le perfluorobutyléthylène, le pentafluoropropène et leurs mélanges.

4. Composition selon la revendication 3, dans laquelle la proportion molaire d'unités X dans le polymère vaut de 0,1 à 15 %, de préférence de 0,5 à 13 %, et de manière plus particulièrement préférée de 1 à 12 %.

5. Composition selon l'une des revendications 1 à 4, dans laquelle ledit monomère (méth)acrylique bi ou polyfonctionnel en termes de doubles liaisons réactives est un monomère ou un oligomère contenant au moins deux double liaisons réactives de type (méth)acryliques ou un monomère ou oligomère (méth)acrylique bi ou polyfonctionnel choisi parmi des diols, triols ou polyols, polyesters, éthers, polyéthers, polyuréthane, époxys, cyanurates ou iso-cyanurates.

6. Composition selon la revendication 5 dans laquelle ledit monomère (méth)acrylique est choisi dans la liste : dodécane diméthacrylate, 1,3-butylène glycol di(méth)acrylate, butanediol di(méth)acrylate, 1,6-hexanediol di(méth)acrylate, hexanediol alkoxylé di(méth)acrylate, néopentyl glycol alkoxylé di(méth)acrylate, dodécyl di(méth) acrylate, cyclohexane diméthanol di(méth)acrylate, diéthylène glycol di(méth)acrylate, dipropylène glycol di(méth)acrylate, les alcanes linéaires di(méth) acrylate, bisphénol A éthoxylé di(méth)acrylate, éthylène glycol di(méth)acrylate, néopentyl glycol di(méth)acrylate, tricyclodécane diméthanol diacrylate, triéthylène glycol di(méth)acrylate, tétraéthylène glycol di(méth)acrylate, tripropylène glycol di(méth)acrylate, ditriméthylolpropane tétra(méth)acrylate, pentaérythritol éthoxylé tétra(méth)acrylate, dipentaérythritol penta(méth)acrylate, penta(méth)acrylate ester, pentaérythritol tétra(méth)acrylate, triméthylolpropane éthoxylé tri(méth)acrylate, triméthylolpropane alkoxylé tri(méth)acrylate, triméthylolpropane tri(méth)acrylate, pentaérythritol tri(méth)acrylate, triméthylolpropane propoxylé tri(méth)acrylate, triméthylolpropane triméthacrylate, dodécanediol di(méth)acrylate, dodécane di(méth)acrylate, dipentaérythritol penta/hexa(méth)acrylate, pentaérythritol tetra(méth)acrylate, di-triméthylolpropane tétra(méth)acrylate, glyceryl propoxylé tri(méth)acrylate, glycéryl propoxylé tri(méth)acrylate, tris (2-hydroxy éthyl) isocyanurate tri(méth)acrylate, polyesters (méth)acrylates, polyéthers (méth)acrylates, polyéthylènes glycol (méth)acrylates, polypropylènes glycol (méth)acrylates, polyuréthanes (méth)acrylates, epoxy (méth)acrylates, et les combinaisons de ceux-ci.

7. Composition selon l'une des revendications 1 à 6, dans laquelle ledit solvant est choisi parmi : les cétones, les furanes, les esters, les carbonates, les amides et les sulfoxydes.

8. Composition selon l'une des revendications 1 à 7, dans laquelle ledit amorceur de polymérisation radicalaire est choisi parmi le 2-hydroxy-2-méthyl-1-phenyl-propan-1-one, 2,4,6-triméthylbenzoyl-diphenyl-phosphineoxide, 2,4,6-trimethylbenzoylphenyl phosphinate, 1-hydroxy-cyclohexyl-phenyl-cétone, bis(2,6-diméthoxybenzoyl)-2,4,4-triméthyl-pentyl phosphine oxyde, 1-[4-(2-hydroxyéthoxy)-phenyl]-2-hydroxy-2-méthyl-1-propane-1-one, 2,2-diméthoxy-1,2-diphenyléthan-1-one et le 2-méthyl-1[4-(méthylthio)phenyl]-2-morpholinopropan-1-one, 2,4-diethylthioxanthone, leurs dérivés, et mélanges de ceux-ci.

9. Composition selon l'une des revendications 1 à 8, dans laquelle :
i. le copolymère fluoré électroactif (a) constitue entre 60% et 99,99% en poids, et de préférence entre 70% et 99% en poids de la somme constituée par les poids des composants (a) et (b),
ii. l'amorceur radicalaire (c) constitue entre 0,1% et 10% en poids et de préférence entre 0,2% et 5% en poids de la somme constituée par les poids des composants (a), (b) et (c),
iii. les additifs (e) constituent de 0,01% jusqu'à moins de 20% en poids du poids de la composition.

10. Film réticulé consistant en au moins un copolymère fluoré électroactif non-réticulé selon l'une des revendications 2 à 4 ou 9 et un copolymère (méth)acrylique réticulé obtenu par réticulation des monomères (méth)acryliques définis dans une des revendications 5 et 6.

11. Procédé de préparation d'un film réticulé, ledit procédé consistant en :
- fournir une composition réticulable selon l'une des revendications 1 à 9, dans laquelle lesdits composants (a), (b), (c) et (e) sont dissous dans ledit solvant (d) pour obtenir une encre,
- déposer ladite encre sur un support, un dispositif ou une partie d'un dispositif (opto)électronique pour former un film,
- sécher ledit film par évaporation partielle ou totale du solvant, et
- réticuler toute ou une partie dudit film par polymérisation du (ou des) monomères (méth)acryliques
- dans le cas de la formation souhaitée d'un motif prédéfini, développer ledit film pour retirer les parties non-réticulées.

12. Procédé selon la revendication 11, dans lequel ledit amorceur radicalaire est un photo-amorceur susceptible d'être activé par de la lumière partiellement ou complètement composée des tranches spectrales comprises entre 150 et 410 nm de longueur d'onde.

13. Procédé selon l'une des revendications 11 ou 12, dans lequel la dose irradiante pour provoquer la réticulation du film est inférieure à 20 J/cm² et de préférence inférieure à 10 J/cm².

14. Dispositif (opto)électronique comprenant, comme couche diélectrique, au moins une couche du film préparé selon le procédé décrit dans l'une des revendications 11 à 13.

15. Dispositif selon la revendication 14, comprenant un empilement d'une ou plusieurs couches déposée(s) sur ladite couche de film.

16. Dispositif selon l'une des revendications 14 ou 15 choisi parmi les transistors à effets de champs et les mémoires ferroélectriques utilisables notamment dans l'électronique organique imprimée.

17. Dispositif selon l'une des revendications 14 ou 15 choisi parmi les actionneurs, les dispositifs haptiques, les condensateurs, les diodes, les capteurs, et les microsystèmes électromécaniques.

## Patentansprüche

1. Vernetzbare Zusammensetzung, die aus Folgendem besteht:
a) mindestens einem elektroaktiven fluorierten Copolymer der allgemeinen Formel P(VDF-TrFE) oder der allgemeinen Formel P(VDF-TrFE-X), wobei VDF für Einheiten steht, die von Vinylidenfluorid stammen, TrFE für Einheiten steht, die von Trifluorethylen stammen, und X für Einheiten steht, die von einem dritten Monomer stammen, das mindestens ein Fluoratom trägt,
b) mindestens einem in Bezug auf reaktive Doppelbindungen bi- oder polyfunktionellen (Meth)Acrylmonomer,
c) mindestens einem Initiator der radikalischen Polymerisation,
d) mindestens einem organischen Lösungsmittel und
e) mindestens einem Additiv, das aus der folgenden Liste ausgewählt ist: in Bezug auf reaktive Doppelbindungen monofunktionelle (Meth)Acrylmonomere, die Oberflächenspannung, die Rheologie, die Alterungsbeständigkeit, die Adhäsion oder die Farbe modifizierende Mittel, Füllstoffe und Nanofüllstoffe;
wobei das elektroaktive fluorierte Copolymer nach einer Aktivierung des Initiators der radikalischen Polymerisation nicht zu einer Polymerisation und/oder Vernetzung fähig ist; das mindestens eine bi- oder polyfunktionelle (Meth)Acrylmonomer zu einer Polymerisation und Vernetzung fähig ist, die nach einer Aktivierung des Initiators der radikalischen Polymerisation initiiert wird, wodurch ein Methacryl-Netzwerk in einer elektroaktiven fluorierten Copolymervernetzten Methacryl-Netzwerk-Struktur gebildet wird.

2. Zusammensetzung nach Anspruch 1, wobei es sich bei dem elektroaktiven fluorierten Copolymer um ein Copolymer der allgemeinen Formel P(VDF-TrFE) handelt, wobei das Molverhältnis VDF:

3. Zusammensetzung nach Anspruch 1, wobei es sich bei dem elektroaktiven fluorierten Copolymer um ein Terpolymer der allgemeinen Formel P(VDF-TrFE-X) handelt, wobei X ausgewählt ist aus: Tetrafluorethylen, Chlorfluorethylen, Chlortrifluorethylen, Hexafluorpropylen, 3,3,3-Trifluorpropen, 1,3,3,3-Tetrafluorpropen (oder 1234ze), 2,3,3,3-Tetrafluorpropen (oder 1234yf), 3-Chlor-2,3,3-trifluorpropen (oder 1233yf), 2-Chlor-3,3,3-trifluorpropen (oder 1233xd), Hexafluorisobutylen, Perfluorbutylethylen, Pentafluorpropen und deren Mischungen.

4. Zusammensetzung nach Anspruch 3, wobei das Molverhältnis von X-Einheiten im Polymer von 0,1 bis 15 %, vorzugsweise von 0,5 bis 13 % und noch mehr bevorzugt von 1 bis 12 % reicht.

5. Zusammensetzung nach einem der Ansprüche 1 bis 4, wobei es sich bei dem in Bezug auf reaktive Doppelbindungen bi- oder polyfunktionelle (Meth)Acrylmonomer um ein Monomer oder ein Oligomer, das mindestens zwei reaktive Doppelbindungen vom (Meth)Acryltyp enthält, oder ein bi- oder polyfunktionelles (Meth)Acrylmonomer oder -oligomer handelt, das aus Diolen, Triolen oder Polyolen, Polyestern, Ethern, Polyethern, Polyurethan, Epoxiden, Cyanuraten oder Isocyanuraten ausgewählt ist.

6. Zusammensetzung nach Anspruch 5, wobei das (Meth)Acrylmonomer aus der folgenden Liste ausgewählt ist: Dodecandimethacrylat, 1,3-Butylenglycoldi(meth)acrylat, Butandioldi(meth)acrylat, 1,6-Hexandioldi(meth)acrylat, alkoxyliertes Hexandioldi(meth)acrylat, alkoxyliertes Neopentylglycoldi(meth)acrylat, Dodecyldi(meth)acrylat, Cyclohexandimethanoldi(meth)acrylat, Diethylenglycoldi(meth)acrylat, Dipropylenglycoldi(meth)acrylat, lineare-Alkane-di(meth)acrylat, ethoxyliertes Bisphenol-A-di(meth)acrylat, Ethylenglycoldi(meth)acrylat, Neopentylglycoldi(meth)acrylat, Tricyclodecandimethanoldiacrylat, Triethylenglycoldi(meth)acrylat, Tetraethylenglycoldi(meth)acrylat, Tripropylenglycoldi(meth)acrylat, Ditrimethylolpropantetra(meth)acrylat, ethoxyliertes Pentaerythrittetra(meth)acrylat, Dipentaerythritpenta(meth)acrylat, Penta(meth)acrylatester, Pentaerythrittetra(meth)acrylat, ethoxyliertes Trimethylolpropantri(meth)acrylat, alkoxyliertes Trimethylolpropantri(meth)acrylat, Trimethylolpropantri(meth)acrylat, Pentaerythrittri(meth)acrylat, propoxyliertes Trimethylolpropantri(meth)acrylat, Trimethylolpropantrimethacrylat, Dodecandioldi(meth)acrylat, Dodecandi(meth)acrylat, Dipentaerythritpenta-/-hexa(meth)acrylat, Pentaerythrittetra(meth)acrylat, Ditrimethylolpropantetra(meth)acrylat, propoxyliertes Glyceryltri(meth)acrylat, propoxyliertes Glyceryltri(meth)acrylat, Tris(2-hydroxyethyl)isocyanurattri(meth)acrylat, Polyester(meth)acrylate, Polyether(meth)acrylate, Polyethylenglycol(meth)acrylate, Polypropylenglycol(meth)acrylate, Polyurethan(meth)acrylate, Epoxy(meth)acrylate und Kombinationen davon.

7. Zusammensetzung nach einem der Ansprüche 1 bis 6, wobei das Lösungsmittel ausgewählt ist aus: Ketonen, Furanen, Estern, Carbonaten, Amiden und Sulfoxiden.

8. Zusammensetzung nach einem der Ansprüche 1 bis 7, wobei der Initiator der radikalischen Polymerisation aus 2-Hydroxy-2-methyl-1-phenylpropan-1-on, 2,4,6-Trimethylbenzoyldiphenylphosphinoxid, 2,4,6-Trimethylbenzoylphenylphosphinat, 1-Hydroxycyclohexylphenylketon, Bis(2,6-dimethoxybenzoyl)-2,4,4-trimethylpentylphosphinoxid, 1-[4-(2-Hydroxyethoxy)phenyl]-2-hydroxy-2-methyl-1-propan-1-on, 2,2-Dimethoxy-1,2-diphenylethan-1-on und 2-Methyl-1[4-(methylthio)phenyl]-2-morpholinopropan-1-on, 2,4-Diethylthioxanthon, deren Derivaten und Mischungen davon ausgewählt ist.

9. Zusammensetzung nach einem der Ansprüche 1 bis 8, wobei:
i. das elektroaktive fluorierte Copolymer (a) zwischen 60 Gew.-% und 99,99 Gew.-% und vorzugsweise zwischen 70 Gew.-% und 99 Gew.-% der Summe darstellt, die aus den Gewichten der Komponenten (a) und (b) besteht,
ii. der Radikalinitiator (c) zwischen 0,1 Gew.-% und 10 Gew.-% und vorzugsweise zwischen 0,2 Gew.-% und 5 Gew.-% der Summe darstellt, die aus den Gewichten der Komponenten (a), (b) und (c) besteht,
iii. die Additive (e) von 0,01 Gew.-% bis weniger als 20 Gew.-% des Gewichts der Zusammensetzung darstellen.

10. Vernetzter Film, der aus mindestens einem unvernetzten elektroaktiven fluorierten Copolymer nach einem der Ansprüche 2 bis 4 oder 9 und einem vernetzten (Meth)Acryl-Copolymer besteht, das durch eine Vernetzung der in einem der Ansprüche 5 und 6 definierten (Meth)Acrylmonomere erhalten wird.

11. Verfahren zur Herstellung eines vernetzten Films, wobei das Verfahren aus Folgendem besteht:
- dem Bereitstellen einer vernetzbaren Zusammensetzung nach einem der Ansprüche 1 bis 9, wobei die Komponenten (a), (b), (c) und (e) in dem Lösungsmittel (d) gelöst sind, wodurch eine Tinte erhalten wird,
- dem Abscheiden der Tinte auf einem Träger, einem Bauelement oder einem Teil eines (opto)elektronischen Bauelements, wodurch ein Film gebildet wird,
- dem Trocknen des Films durch ein partielles oder vollständiges Abdampfen des Lösungsmittels und
- dem Vernetzen des gesamten oder eines Teils des Films durch eine Polymerisation des (Meth)Acrylmonomers (oder der (Meth)Acrylmonomere),
- im Fall der gewünschten Bildung eines vordefinierten Musters dem Entwickeln des Films, um die unvernetzten Teile zu entfernen.

12. Verfahren nach Anspruch 11, wobei es sich bei dem radikalischen Initiator um einen Fotoinitiator handelt, der durch Licht aktivierbar ist, das teilweise oder vollständig aus Spektralabschnitten mit einer Wellenlänge zwischen 150 und 410 nm besteht.

13. Verfahren nach einem der Ansprüche 11 oder 12, wobei die Strahlendosis zum Hervorrufen der Vernetzung des Films weniger als 20 J/cm² und vorzugsweise weniger als 10 J/cm² beträgt.

14. (Opto)Elektronisches Bauelement, das als dielektrische Schicht mindestens eine Schicht des Films umfasst, der gemäß dem in einem der Ansprüche 11 bis 13 beschriebenen Verfahren hergestellt ist.

15. Bauelement nach Anspruch 14, das einen Stapel einer oder mehrerer Schichten umfasst, die auf der Filmschicht abgeschieden sind.

16. Bauelement nach einem der Ansprüche 14 oder 15, das aus Feldeffekttransistoren und ferroelektrischen Speichern ausgewählt ist, die insbesondere in der gedruckten organischen Elektronik verwendbar sind.

17. Bauelement nach einem der Ansprüche 14 oder 15, das aus Aktoren, haptischen Bauelementen, Kondensatoren, Dioden, Sensoren und elektromechanischen Mikrosystemen ausgewählt ist.

## Claims

1. Crosslinkable composition consisting of:
a) at least one electroactive fluorinated copolymer of general formula P(VDF-TrFE) or of general formula P(VDF-TrFE-X), in which VDF represents units derived from vinylidene fluoride, TrFE represents units derived from trifluoroethylene and X represents units derived from a third monomer bearing at least one fluorine atom,
b) at least one (meth)acrylic monomer which is bifunctional or polyfunctional in terms of reactive double bonds,
c) at least one radical polymerization initiator,
d) at least one organic solvent, and
e) at least one additive chosen from the list: (meth)acrylic monomers which are monofunctional in terms of reactive double bonds, agents which modify surface tension, rheology, ageing resistance, adhesion or colour, fillers and nanofillers;
the electroactive fluorinated copolymer not being capable of polymerization and/or crosslinking after activation of the radical polymerization initiator; the at least one bifunctional or polyfunctional (meth)acrylic monomer being capable of polymerization and crosslinking initiated after activation of the radical polymerization initiator to form a methacrylic network within an electroactive fluorinated copolymer-methacrylic crosslinked network structure.

2. Composition according to Claim 1, in which said electroactive fluorinated copolymer is a copolymer of general formula P(VDF-TrFE), the VDF:TrFE molar ratio in the polymer ranging from 50:50 to 85:15.

3. Composition according to Claim 1, in which said electroactive fluorinated copolymer is a terpolymer of general formula P(VDF-TrFE-X), in which X is chosen from: tetrafluoroethylene, chlorofluoroethylene, chlorotrifluoroethylene, hexafluoropropylene, 3,3,3-trifluoropropene, 1,3,3,3-tetrafluoropropene (or 1234ze), 2,3,3,3-tetrafluoropropene (or 1234yf), 3-chloro-2,3,3-trifluoropropene (or 1233yf), 2-chloro-3,3,3-trifluoropropene (or 1233xd), hexafluoroisobutylene, perfluorobutylethylene, pentafluoropropene and mixtures thereof.

4. Composition according to Claim 3, in which the molar proportion of X units in the polymer is from 0.1% to 15%, preferably from 0.5% to 13%, and more particularly preferably from 1% to 12%.

5. Composition according to one of Claims 1 to 4, in which said (meth)acrylic monomer which is bifunctional or polyfunctional in terms of reactive double bonds is a monomer or an oligomer containing at least two reactive double bonds of (meth)acrylic type or a bifunctional or polyfunctional (meth)acrylic monomer or oligomer chosen from diols, triols or polyols, polyesters, ethers, polyethers, polyurethane, epoxies, cyanurates or isocyanurates.

6. Composition according to Claim 5, in which said (meth)acrylic monomer is chosen from the list: dodecane dimethacrylate, 1,3-butylene glycol di(meth)acrylate, butanediol di(meth)acrylate, 1,6-hexanediol di(meth)acrylate, alkoxylated hexanediol di(meth)acrylate, alkoxylated neopentyl glycol di(meth)acrylate, dodecyl di(meth)acrylate, cyclohexane dimethanol di(meth)acrylate, diethylene glycol di(meth)acrylate, dipropylene glycol di(meth)acrylate, linear alkane di(meth)acrylates, ethoxylated bisphenol A di(meth)acrylate, ethylene glycol di(meth)acrylate, neopentyl glycol di(meth)acrylate, tricyclodecane dimethanol diacrylate, triethylene glycol di(meth)acrylate, tetraethylene glycol di(meth)acrylate, tripropylene glycol di(meth)acrylate, ditrimethylolpropane tetra(meth)acrylate, ethoxylated pentaerythritol tetra(meth)acrylate, dipentaerythritol penta(meth)acrylate, penta(meth)acrylate ester, pentaerythritol tetra(meth)acrylate, ethoxylated trimethylolpropane tri(meth)acrylate, alkoxylated trimethylolpropane tri(meth)acrylate, trimethylolpropane tri(meth)acrylate, pentaerythritol tri(meth)acrylate, propoxylated trimethylolpropane tri(meth)acrylate, trimethylolpropane trimethacrylate, dodecanediol di(meth)acrylate, dodecane di(meth)acrylate, dipentaerythritol penta/hexa(meth)acrylate, pentaerythritol tetra(meth)acrylate, ditrimethylolpropane tetra(meth)acrylate, propoxylated glyceryl tri(meth)acrylate, propoxylated glyceryl tri(meth)acrylate, tris(2-hydroxyethyl) isocyanurate tri(meth)acrylate, polyester (meth)acrylates, polyether (meth)acrylates, polyethylene glycol (meth)acrylates, polypropylene glycol (meth)acrylates, polyurethane (meth)acrylates, epoxy (meth)acrylates, and combinations thereof.

7. Composition according to one of Claims 1 to 6, in which said solvent is chosen from: ketones, furans, esters, carbonates, amides and sulfoxides.

8. Composition according to one of Claims 1 to 7, in which said radical polymerization initiator is chosen from 2-hydroxy-2-methyl-1-phenylpropan-1-one, 2,4,6-trimethylbenzoyl-diphenylphosphine oxide, 2,4,6-trimethylbenzoylphenyl phosphinate, 1-hydroxycyclohexyl phenyl ketone, bis(2,6-dimethoxybenzoyl)-2,4,4-trimethylpentylphosphine oxide, 1-[4-(2-hydroxyethoxy)phenyl]-2-hydroxy-2-methyl-1-propan-1-one, 2,2-dimethoxy-1,2-diphenylethan-1-one and 2-methyl-1-[4-(methylthio)phenyl]-2-morpholinopropan-1-one, 2,4-diethylthioxanthone, derivatives thereof, and mixtures thereof.

9. Composition according to one of Claims 1 to 8, in which:
i. the electroactive fluorinated copolymer (a) constitutes between 60% and 99.99% by weight, and preferably between 70% and 99% by weight, of the sum consisting of the weights of the components (a) and (b),
ii. the radical initiator (c) constitutes between 0.1% and 10% by weight, and preferably between 0.2% and 5% by weight, of the sum consisting of the weights of the components (a), (b) and (c),
iii. the additives (e) constitute from 0.01% up to less than 20% by weight of the weight of the composition.

10. Crosslinked film consisting of at least one non-crosslinked electroactive fluorinated copolymer according to one of Claims 2 to 4 or 9 and one crosslinked (meth)acrylic copolymer obtained by crosslinking the (meth)acrylic monomers defined in either of Claims 5 and 6.

11. Process for preparing a crosslinked film, said process consisting in:
- providing a crosslinkable composition according to one of Claims 1 to 9, in which said components (a), (b), (c) and (e) are dissolved in said solvent (d) so as to obtain an ink,
- depositing said ink on a support, a device or a part of a device which is (opto)electronic so as to form a film,
- drying said film by partial or total evaporation of the solvent, and
- crosslinking all or a part of said film by polymerization of the (meth)acrylic monomer(s),
- in the case of the desired formation of a predefined pattern, developing said film in order to remove the non-crosslinked parts.

12. Process according to Claim 11, in which said radical initiator is a photoinitiator capable of being activated by light partially or completely composed of the spectral cross sections between the wavelengths 150 and 410 nm.

13. Process according to either of Claims 11 and 12, in which the irradiating dose for bringing about the crosslinking of the film is less than 20 J/cm² and preferably less than 10 J/cm².

14. (Opto)electronic device comprising, as dielectric layer, at least one layer of the film prepared according to the process described in one of Claims 11 to 13.

15. Device according to Claim 14, comprising a stack of one or more layers deposited on said layer of film.

16. Device according to either of Claims 14 and 15, chosen from field-effect transistors and ferroelectric memories that can be used in particular in printed organic electronics.

17. Device according to either of Claims 14 and 15, chosen from actuators, haptic devices, condensers, diodes, sensors, and electromechanical microsystems.
